# EUROPÄISCHE PATENTSCHRIFT

(11) **EP 2 664 932 B1**
(45) Veröffentlichungstag und Bekanntmachung des Hinweises auf die Patenterteilung: **01.08.2018**
(21) Anmeldenummer: 13167780.9
(22) Anmeldetag: 15.05.2013
(51) Int. Cl.: G01R 31/12, H02H 7/125, H02M 7/04, G01R 27/18, G01R 31/02

(54) **Pulsgenerator-Schaltungsanordnung und Verfahren zur Erzeugung von Pulssignalen für die Isolationsfehlersuche in IT-Netzen**
Pulse generator circuit assembly and method for producing pulse signals for insulation error finding in ungrounded networks
Agencement de circuit de générateur d'impulsions et procédé de génération de signaux à impulsions pour la recherche d'erreurs d'isolation dans des réseaux Isolé Terre.

(30) Priorität: 15.05.2012 DE 102012208111
(43) Veröffentlichungstag der Anmeldung: 20.11.2013
(73) Patentinhaber: Bender GmbH & Co. KG, 35305 Grünberg (DE)
(72) Erfinder: Weiß, Carsten, 35321 Laubach (DE); Groh, Tobias, 35325 Mücke (DE)
(74) Vertreter: advotec.

(56) Entgegenhaltungen:
- EP-A1- 0 654 673
- DE-A1- 19 826 410
- DE-B3-102004 018 918
- DE-B3-102005 052 956

## Beschreibung

Die Erfindung betrifft eine Pulsgenerator-Schaltungsanordnung zur Isolationsfehlersuche in IT-Netzen, mit einer Gleichrichterschaltung zur Umwandlung der IT-Netzspannung in einen DC-Zwischenkreis, Schaltgliedern mit einem Triggersignaleingang zur Auf- und Abschaltung einer DC-Zwischenkreisspannung und mit einer den Schaltgliedern nachgeordneten Schaltungseinrichtung zur Erzeugung eines in das IT-Netz einzuspeisenden Pulsstroms.

Weiterhin betrifft die Erfindung ein Verfahren zur Erzeugung von Pulssignalen zur Isolationsfehlersuche in IT-Netzen, umfassend die Signalverarbeitungsschritte: Umwandlung einer IT-Netzspannung in einen DC-Zwischenkreis mittels einer Gleichrichterschaltung, getriggerte Auf- und Abschaltung einer DC-Zwischenkreisspannung durch Schaltglieder mit einem Triggersignaleingang und Erzeugung eines in das IT-Netz einzuspeisenden Pulsstroms.

Um eine hohe Verfügbarkeit und Betriebssicherheit der elektrischen Stromversorgung sicherzustellen sowie die Personensicherheit im Bereich elektrischer Anlagen zu gewährleisten, kommen in zunehmendem Maße Stromversorgungsnetze zum Einsatz, deren aktive Teile von dem Erdpotential getrennt sind. Bei dieser als ungeerdetes IT-System bezeichneten Art des Stromversorgungsnetzes kann ein aktiver Leiter einen Isolationsfehler aufweisen, ohne dass der laufende Betrieb der Anlage unterbrochen werden muss, weil sich wegen des im Idealfall unendlich großen Impedanzwertes zwischen Leiter und Erde in diesem ersten Fehlerfall kein geschlossener Stromkreis ausbilden kann. Als Isolationsfehler wird dabei ein fehlerhafter Zustand des IT-Systems, insbesondere ein Körper- oder Erdschluss, also eine leitende Verbindung inaktiver Anlagenteile mit leitenden Betriebsmitteln oder eine leitende Verbindung eines aktiven Leiters gegen Erde, verstanden.

Aus dieser Betrachtung geht hervor, dass der Widerstand in dem zu überwachenden Netz, einschließlich der Widerstände aller daran angeschlossenen Betriebsmittel gegen Erde (Isolationswiderstand) ständig überwacht werden muss, da durch einen möglichen weiteren Fehler an einem anderen aktiven Leiter (zweiter Fehler) eine Fehlerschleife entstünde und der darin fließende Fehlerstrom in Verbindung mit einer Überstrom-Schutzeinrichtung eine Abschaltung der Anlage zur Folge hätte. Mit einer ständigen Isolationsüberwachung des ungeerdeten IT-Systems kann ein Absinken des Isolationswiderstands rechtzeitig erkannt und gemeldet werden.

Dem Stand der Technik gemäß beruhen die Messverfahren zur Bestimmung des Isolationswiderstandes prinzipiell auf der Überlagerung einer in einem Isolationsüberwachungsgerät erzeugten Messspannung zwischen den Leitern des IT-Netzes und Erde, so dass sich ein bestimmter, dem Isolationsfehler proportionaler Messstrom einstellt, der an einem Messwiderstand des Isolationsüberwachungsgerätes einen entsprechenden Spannungsabfall hervorruft. Überschreitet der Spannungsabfall infolge eines abgesunkenen Isolationswiderstands und damit eines höheren Messstroms einen bestimmten Wert, so wird eine Meldung ausgelöst. Um im Hinblick auf eine zuverlässige Isolationsüberwachung in heutigen modernen Netzen, in denen eine Vielzahl von Betriebsmitteln mit elektronischen Bauelementen versehen ist, Messverfälschungen entgegenzuwirken, hervorgerufen beispielsweise durch von Umrichtern erzeugte Gleichstromkomponenten, sind die Messverfahren stets weiter entwickelt worden. In reinen Wechselstromnetzen ohne verfälschende Gleichspannungsanteile kann das Verfahren der Überlagerung einer Messgleichspannung eingesetzt werden, wohingegen in störungsbehafteten Umgebungen eine gesteuerte, speziell getaktete Messspannung zum Treiben von Pulssignalen zur Anwendung gelangt.

Ist ein Absinken des Isolationswiderstandes erkannt, startet die Isolationsfehlersuche indem das Isolationsüberwachungsgerät oder ein separates Prüfgerät einen Prüfstrom erzeugt und in das IT-Netz einspeist. Um Isolationsfehler in einem DC-Netz zuverlässig erkennen zu können und auf Grund der verfügbaren Messtechnik besitzt auch der zur Isolationsfehlersuche eingespeiste Prüfstrom vorzugsweise einen impulsförmigen Verlauf mit alternierender Polarität (Pulsstrom), so dass abwechselnd beide Leiter (L+ und L-) vom Prüfstrom durchflossen werden. Dieses Prüfstromsignal wird von allen Messstromwandlern, die im fehlerbehafteten Leitungsabgang des Netzes liegen, erfasst und durch ein Isolationsfehler-Auswertegerät ausgewertet und angezeigt. Durch die Zuordnung Messstromwandler/Stromkreis bzw. Leitungsabgang kann der Fehlerort lokalisiert werden.

Als nachteilig erweist sich bei dieser nach dem Stand der Technik üblichen Vorgehensweise, dass die Bestimmung des Isolationswiderstands und die Lokalisierung von Isolationsfehlern zwei getrennte, in sich abgeschlossene Prozesse darstellen. Dies hat zur Folge, dass beispielsweise zur Durchführung einer erneuten Messung des Isolationswiderstands während der bereits eingeleiteten Fehlersuche die Einspeisung der Prüfimpulse unterbrochen werden muss, um mit einer geeigneten Messspannung die Isolationswiderstandsmessung durchführen zu können.

Eine zeitgleiche Bestimmung des Isolationswiderstands während der Fehlersuche ist somit nicht in einfacher Weise möglich.

Des Weiteren bieten zwar Geräte nach dem Stand der Technik die Möglichkeit, bei der Fehlersuche den Prüfstrom durch entsprechende Schaltungseinrichtungen wie Stromregler während der Impulsdauer zu stabilisieren und auf einen oder mehrere Maximalwerte zu begrenzen, aber diese Einstellungen stellen nur eine relativ grobe Anpassung des Pulsstromes an die Netzverhältnisse dar, so dass oftmals ein unnötig hoher Pulsstrom generiert wird. Dabei kann es in der Generatorschaltung zu einer übermäßigen Wärmeentwicklung kommen, der bislang durch die Verwendung von großflächigen Kühlkörpern oder Übertemperaturabschaltungen begegnet wurde. In nachteiliger Weise führen diese Gegenmaßnahmen damit direkt oder indirekt über Betriebsunterbrechungen zu Kostensteigerungen.

Darüber hinaus steht in abgeschalteten zu untersuchenden IT-Systemen eine den Pulsstrom treibende Spannung nicht zur Verfügung. Hier stellt sich also grundsätzlich das Problem einer geeigneten Spannungsversorgung zur Erzeugung des Prüfstroms.

Zum Stand der Technik gehört DE 10 2005 052 956.

Der vorliegenden Erfindung liegt somit die Aufgabe zu Grunde, eine Pulsgenerator-Schaltungsanordnung und ein Verfahren zur Erzeugung von Pulssignalen zur Isolationsfehlersuche in IT-Netzen zu entwickeln, die den Prozess einer mit der Isolationsüberwachung verbundenen Isolationsfehlersuche vereinfachen und auch in abgeschalteten IT-Netzen verwendbar bzw. anwendbar sind.

Diese Aufgabe wird bezogen auf eine Schaltungsanordnung in Verbindung mit dem Oberbegriff des Anspruchs 1 gelöst durch eine Steuer- und Auswertelogik zur Bestimmung des Isolationswiderstands des IT-Netzes und durch eine Schaltungseinrichtung zur Erzeugung des Pulsstroms, die als Stromregelungseinrichtung ausgeführt ist, die eine dynamische Einstellung des Pulsstromes in Abhängigkeit des ermittelten Isolationswiderstandes ermöglicht.

Erfindungsgemäß ist in die Pulsgenerator-Schaltungsanordnung eine Steuer- und Auswertelogik integriert, die in der Lage ist, den Isolationswiderstand eines angeschlossenen IT-Netzes während der Erzeugung eines Pulsstroms zu bestimmen. Damit ergibt sich in vorteilhafter Weise die Möglichkeit, mit der Pulsgenerator-Schaltungsanordnung zeitgleich mit der Fehlersuche auch eine Isolationswiderstandsbestimmung durchführen zu können. Es ist nicht erforderlich, während der Fehlersuche die Pulssequenz zu unterbrechen, um eine Isolationswiderstandsmessung ausführen zu können.

Ausgangspunkt der vorliegenden Erfindung ist die grundsätzliche Betrachtung, dass bei einem Isolationsfehler ein Prüfstrom I_{T} (Pulsstrom) in einem Stromkreis fließt, der als Quellenspannung U₀ die IT-Netzspannung bzw. eine daraus abgeleitete DC-Zwischenkreisspannung besitzt und dessen elektrischer Widerstand sich aus der Reihenschaltung eines Isolationsfehlerwiderstands R_{F} (Isolationswiderstand im Fehlerfall) und eines veränderlichen Innenwiderstands R_{PG} des Pulsgenerators ergibt. Soll nun ein vorgegebener, innerhalb einer Impulsdauer konstanter Prüfstrom I_{T} fließen, so stellt sich bei der bekannten DC-Zwischenkreisspannung U₀ ein bestimmter Wert des Innenwiderstands R_{PG} des Pulsgenerators ein. Der Innenwiderstand R_{PG} des Pulsgenerators ist intern bestimmbar, so dass sich nach dem ohmschen Gesetz und den in linearen Netzen geltenden Strom-Spannungsbeziehungen der Isolationsfehlerwiderstand R_{F} berechnen lässt aus: R_{F} = (U₀/I_{T}) - R_{PG}. Um einen - innerhalb der Impulsdauer in eingeschwungenem Zustand - konstanten Pulsstrom zu erzeugen, ist die Schaltungseinrichtung zur Erzeugung des Pulsstroms als Stromregelungseinrichtung ausgeführt, die unter Einbeziehung des ermittelten Isolationswiderstandswertes eine dynamische Einstellung des Pulsstromes gestattet. Durch diese adaptive Einstellung kann der Pulsstrom an den durch den ermittelten Isolationswiderstand repräsentierten elektrischen Zustand des zu untersuchenden Netzes angepasst werden. Einerseits bewegt sich der Pulsstrom damit in einem Bereich, in dem der Isolationswiderstand exakt ermittelt werden kann, zum anderen ergibt sich automatisch auch eine an die Netzverhältnisse angepasste Einstellung des Pulsstromes.

In vorteilhafter Ausgestaltung weist die Stromregelungseinrichtung zur dynamischen Einstellung des Pulsstromes daher eine Regellogik auf, die eingangsseitig mit einer Strommesseinrichtung zur Ermittlung eines Strom-Istwertes des IT-Netzes sowie zur Einbeziehung eines von dem Isolationswiderstand abhängigen Strom-Sollwertes mit der Steuer- und Auswertelogik verbunden ist und die ausgangseitig eine Stellgröße bereitstellt, die über ein Stellglied den Strom-Istwert verändert, so dass sich am Ausgang des Stellgliedes ein angepasster Ausgangsstromwert einstellt.

Nach den vorangegangenen Überlegungen ist der Isolationswiderstand prinzipiell mit einem beliebigen konstanten Prüf-/Pulsstrom ermittelbar. Folgende praktische Erwägungen jedoch führen zu der Notwendigkeit, den Prüfstrom verändern zu können: Erstens ist der Messbereich begrenzt durch den minimal erreichbaren Innenwiderstand R_{PG} des Pulsgenerators sowie durch die zur Verfügung stehende Quellenspannung U₀. Zweitens muss je nach Schaltungskonzept eine (zu) hohe thermische Verlustleistung abgeführt werden. Drittens ergäben sich bei nichtlinearem Verhalten Arbeitsbereiche des Stellgliedes mit hoher Empfindlichkeit und mit geringer Empfindlichkeit gegenüber der Stellgröße, wobei in Bereichen mit niedriger Empfindlichkeit der Innenwiderstand R_{PG} des Pulsgenerators besonders genau ermittelt werden kann.

Die Regellogik berechnet somit auf der Basis eines von einer Strommesseinrichtung ermittelten Strom-Istwertes des IT-Netzes und einem von der Steuer- und Auswertelogik zugeführten, von dem ermittelten Isolationswiderstand abgeleiteten Strom-Sollwert zunächst eine Stellgröße. Diese Stellgröße wirkt über ein Stellglied, dem ebenfalls der in der Strommesseinrichtung ermittelte Strom-Istwert des IT-Netzes zugeführt wird, auf den Strom-Istwert ein, so dass ein entsprechend der Regellogik veränderter Ausgangsstrom generiert wird.

Weiterhin ist die Steuer- und Auswertelogik zur Bestimmung des ohmschen Anteils des Isolationswiderstands eingangsseitig mit dem Stellgrößenausgang der Regellogik und mit einer Spannungsmesseinrichtung zur Messung der IT-Netzspannung verbunden und gibt ausgangsseitig einen Strom-Sollwert an die Regellogik und ein internes Triggersignal an die Schaltglieder zur Auf- und Abschaltung der DC-Zwischenkreisspannung weiter.

Die Pulsgenerator-Schaltungsanordnung umfasst mit Vorteil eine Spannungsmesseinrichtung zur Ermittlung der Netzspannung des IT-Systems. Aus dieser Netzspannung und der von der Regellogik zugeführten Stellgröße kann die Steuer- und Auswertelogik den ohmschen Anteil des Isolationswiderstandes bestimmen. Eine von diesem ohmschen Anteil abgeleitete Größe wird als variabler Strom-Sollwert der Regellogik zugeführt und dient damit als Führungsgröße der Stromregelungseinrichtung.

Bevorzugt weist die Steuer- und Auswertelogik weitere Eingänge für einen extern zugeführten System-Sollwert des Pulsstromes und für ein extern zugeführtes systemweites Triggersignal für die Pulsstromsequenz auf.

Damit können der Pulsgenerator-Schaltungsanordnung von außen ein System-Sollwert des Pulsstromes sowie ein systemweites Triggersignal für die Pulsstromsequenz vorgegeben und bei der Berechnung des Strom-sollwertes für die Regellogik sowie bei der Ableitung des internen Triggersignals berücksichtigt werden.

Vorzugsweise weist die Pulsgenerator-Schaltungsanordnung ein zusätzliches Netzteil auf, das mittels einer externen Versorgungsspannung aus einem weiteren Stromversorgungsnetz eine galvanisch getrennte DC-Spannung in den DC-Zwischenkreis einspeist. Damit ist die Möglichkeit geschaffen, auch bei abgeschalteten IT-Systemen einen (Prüf-)Strom generieren und eine Fehlersuche durchführen zu können.

Die der Erfindung zu Grunde liegende Aufgabe wird bezogen auf ein Verfahren in Verbindung mit dem Oberbegriff des Anspruchs 6 weiterhin gelöst durch eine Bestimmung des Isolationswiderstands des IT-Netzes mittels einer Steuer- und Auswertelogik und durch die Erzeugung des in das IT-Netz eingespeisten Pulsstroms mittels einer Stromregelungseinrichtung derart, dass eine dynamische Einstellung des Pulsstromes in Abhängigkeit des ermittelten Isolationswiderstandes erfolgt.

Korrespondierend zu den Vorrichtungsmerkmalen der erfindungsgemäßen Pulsgenerator-Schaltungsanordnung umfasst das beanspruchte Verfahren in einem erfindungsgemäßen Verfahrensschritt eine Bestimmung des Isolationswiderstands, die zeitgleich mit einer Isolationsfehlersuche erfolgt. Weiterhin wird erfindungsgemäß der eingespeiste Pulsstrom dynamisch unter mittelbarer Einbeziehung des Isolationswiderstands über die Variation des Strom-Sollwertes eingestellt. Die parallel verlaufende Durchführung von Isolationswiderstandsmessung und Isolationsfehlersuche bietet den Vorteil, dass in einfacher Weise während der Isolationsfehlersuche der Isolationswiderstand wiederholt geprüft werden kann und der so ermittelte Wert des Isolationswiderstandes zur Regelung des einzuspeisenden Pulsstroms herangezogen werden kann.

Daher erfolgt in einer bevorzugten Ausgestaltung die Stromregelung zur dynamischen Einstellung des Pulsstromes durch eine Regellogik, die aus einem von einer Strommesseinrichtung zugeführten Strom-Istwert des IT-Netzes und einem von der Steuer- und Auswertelogik zugeführten Isolationswiderstands-abhängigen Strom-Sollwert eine Stellgröße berechnet, die über ein Stellglied den Strom-Istwert verändert, so dass sich am Ausgang des Stellgliedes ein angepasster Ausgangsstromwert einstellt.

Zunächst wird daher mittels einer Strommesseinrichtung der tatsächlich in dem zu untersuchenden IT-Netz fließende Strom ermittelt und als Strom-Istwert einer Regellogik sowie einem Stellglied zugeführt. Als Soll-Größe erhält die Regellogik von der Steuer- und Auswertelogik einen Isolationswiderstands-abhängigen Strom-Sollwert vorgegeben. Aus diesen beiden Eingangsgrößen berechnet die Regellogik entsprechend dem implementierten Reglerverhalten eine Stellgröße, auf deren Basis ein Prüfstrom vorgegeben wird, bei beim der Isolationswiderstand möglichst exakt berechnet werden kann. Die Stellgröße verändert über das Stellglied den Strom-Istwert, so dass sich der gewünschte, dynamisch angepasste Ausgangsstromwert einstellt. Beispielsweise könnte die Strategie verfolgt werden, den Pulsstrom so einzustellen, dass sich eine Stellgröße/ein Stellgrößenfaktor von etwa 50% ergibt. Bei Änderungen des Isolationswiderstandswertes stünde dann noch genügende Spielraum zur Verfügung, um nicht den Prüfstrom sofort wieder neu anpassen zu müssen.

Vorzugsweise werden zur Bestimmung des ohmschen Anteils des Isolationswiderstandes in der Steuer- und Auswertelogik als Eingangsgrößen die von der Regellogik gelieferte Stellgröße und die von der Spannungsmesseinrichtung bereitgestellte IT-Netzspannung herangezogen, wobei die Steuer- und Auswertelogik den in Abhängigkeit des ermittelten Isolationswiderstands veränderlichen Strom-Sollwert an die Regellogik weitergibt. Die zeitgleich zur Pulsstrom-Einspeisung ausgeführte Bestimmung des ohmschen Anteils des Isolationswiderstandes erfolgt aus einer Spannungs-/Strommessung wobei die IT-Netzspannung von einer unmittelbar an das IT-Netz angeschlossenen Spannungsmesseinrichtung ermittelt wird. Der benötigte Stromwert wird durch die von der Regellogik gelieferte Stellgröße abgebildet.

Vorzugsweise erfolgt die dynamische Einstellung des Pulsstromes nach einem oder mehreren der Kriterien a) Optimierung des Arbeitsbereichs des Stellgliedes, b) Stellgröße in einem Bereich, der eine möglichst genaue Bestimmung des Isolationswiderstandes erlaubt, c) Minimierung der Verlustleistung des Stellgliedes.

Das Regelverhalten kann somit daraufhin ausgelegt werden, dass das Stellglied in einem optimalen Arbeitsbereich arbeitet, also nicht an den Grenzen seiner Einstellbereiche angesteuert wird und/oder die Regelung kann so ausgelegt sein, dass die Verlustleistung des Stellgliedes minimiert wird. Daneben ist auch eine Einstellung des Pulsstromes derart möglich, dass sich die Stellgröße in einem Bereich bewegt, der eine möglichst genaue Bestimmung des Isolationswiderstands erlaubt, in dem somit die Messungenauigkeiten minimal sind.

Bevorzugt weist der Pulsstrom einen impulsförmigen, alternierenden Verlauf auf. Die bisher verfügbare und eingesetzte Messtechnik zur Isolationsfehlersuche kann einen impulsförmigen Verlauf des Pulsstromes notwendig machen. Zudem ist es zweckmäßig, dass die Impulse eine alternierende Polarität aufweisen, damit beide Leiter eines IT-Netzes vom Prüfstrom durchflossen werden.

Um in abgeschalteten IT-Systemen - wenn eine den (Puls-)Strom treibende Netzspannungsquelle nicht zur Verfügung steht - dennoch eine Fehlersuche durchführen zu können, ist vorgesehen, eine galvanisch getrennte DC-Spannung mittels einer externen Versorgungsspannung aus einem weiteren Stromversorgungsnetz in den DC-Zwischenkreis einzuspeisen.

Weitere vorteilhafte Ausgestaltungsmerkmale ergeben sich aus der nachfolgenden Beschreibung und den Zeichnungen, die eine bevorzugte Ausführungsform der Erfindung an Hand eines Beispiels erläutern. Es zeigen:
- **Fig. 1:**: ein Ersatzschaltbild eines Prüfstromkreises,
- **Fig. 2:**: ein funktionales Blockschaltbild einer erfindungsgemäßen Pulsgenerator-Schaltungsanordnung,
- **Fig. 3:**: einen Pulsgenerator nach dem Stand der Technik.

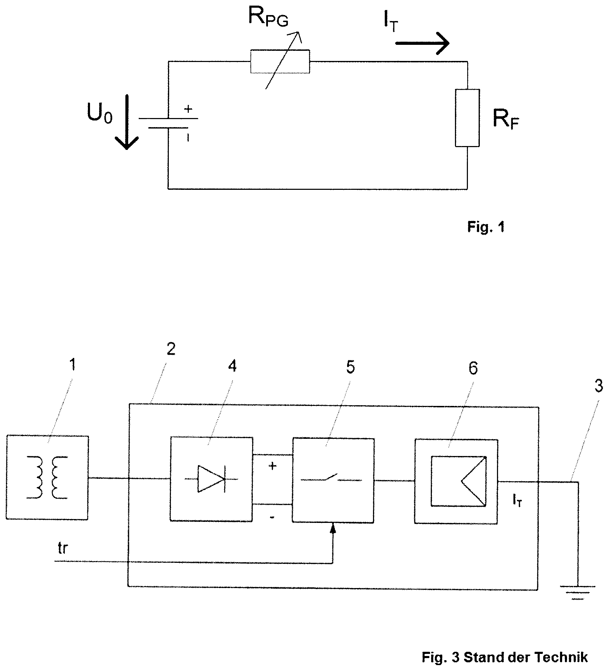

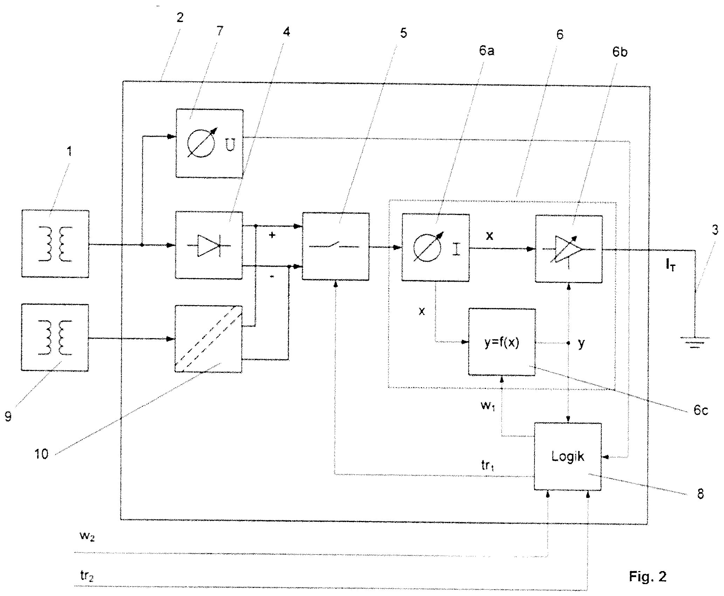

**Fig.1** zeigt ein vereinfachtes Ersatzschaltbild eines Prüfstromkreises zur Bestimmung eines Isolationsfehlerwiderstands R_{F} eines IT-Netzes mit konstantem Prüfstrom I_{T}. Die Quellenspannung U₀, die eine Netzspannung oder eine daraus abgeleitete Zwischenkreisspannung sein kann, treibt einen Prüfstrom I_{T} durch den von dem Isolationsfehlerwiderstand R_{F} und dem veränderlichen Innenwiderstand R_{PG} des Pulsgenerators geschlossenen Stromkreis. Soll ein vorgegebener Prüfstrom I_{T} fließen, so stellt sich nach dem ohmschen Gesetz und den in linearen Netzen geltenden Strom-Spannungsbeziehungen ein bestimmter Innenwiderstand R_{PG} des Pulsgenerators ein. Dieser Innenwiderstand R_{PG} ist aus internen Größen (siehe Fig. 2) des Pulsgenerators bestimmbar, so dass daraus der Isolationsfehlerwiderstand ermittelt werden kann: R_{F} = (U₀/I_{T}) - R_{PG}.

**Fig. 2** zeigt ein funktionales Blockschaltbild einer erfindungsgemäßen Pulsgenerator-Schaltungsanordnung 2 in einem IT-System. Der Pulsgenerator 2 ist über seine Systemanschlüsse mit den aktiven Leitern eines IT-Netzes 1 und über den Erdanschluss mit der Erdleitung 3 verbunden. Mit einer Gleichrichterschaltung 4 wird eine Wechselspannung des IT-Netzes 1 zunächst in eine DC-Zwischenkreisspannung umgewandelt und anschließend mittels Schaltgliedern 5 getaktet, sodass sie als eine einen Pulsstrom-treibende Spannungsquelle dienen kann. Zur Taktung wird den Schaltgliedern 5 ein internes Triggersignal tr₁ zugeführt.

Der Pulsstrom I_{T} wird durch eine als Stromregelungseinrichtung 6 ausgeführte Schaltungseinrichtung 6 dynamisch eingestellt, wobei eine von dem zuvor bestimmten Isolationswiderstand abhängige SollwertVorgabe mit einem Strom-Sollwert w₁ als variable Führungsgröße erfolgt. Mit dieser adaptiven Regelung kann die Größe des erzeugten Pulsstromes I_{T} so eingestellt werden, dass gleichzeitig mit der Isolationsfehlersuche eine Bestimmung des Isolationswiderstands erfolgt.

Die Stromregelungseinrichtung 6 setzt sich funktional aus einer Strommesseinrichtung 6a, einem Stellglied 6b und einer Regellogik 6c zusammen. Dabei wird der durch die getaktete DC-Zwischenkreisspannung getriebene Pulsstrom I_{T} mittels der Strommesseinrichtung 6a bestimmt und als Strom-Istwert x dem Stellglied 6b sowie der Regellogik 6c zugeführt. Die Regellogik 6c empfängt neben dem Strom-Istwert x den internen Strom-Sollwert w₁ von einer Steuer- und Auswertelogik 8 und berechnet entsprechend einem implementierten Regelalgorithmus ein Stellsignal y (Stellgröße). Das Stellsignal y wird dem Stellglied 6b zugeleitet, um den Strom-Istwert x so zu verändern, dass sich ein gewünschter Pulsstrom I_{T} am Ausgang des Stellgliedes 6b einstellt.

Wie aus oben dargestelltem Sachverhalt zur Bestimmung des Isolationswiderstands hervorgeht, ist der Innenwiderstand R_{PG} des Pulsgenerators variabel und wird in erster Linie bestimmt durch den Widerstand des Stellgliedes 6b. Dieser ergibt sich durch seine Ansteuerung mittels der Stellgröße y, wobei hier vereinfachend ein linearer Zusammenhang angenommen sei. Bei einer großen Stellgröße y ergibt sich in eingeschwungenem Zustand der Regelung ein großer elektrischer Leitwert, da das Stellglied 6b gut leitet. Dagegen stellt sich bei einer kleinen Stellgröße y ein kleiner Leitwert ein, da das Stellglied 6b sperrt. Der (Innen-)Leitwert G_{PG} ist somit durch einen von der Stellgröße y gebildeten Faktor einstellbar: G_{PG} = Faktor*Soll-Leitwert. Damit ist auch der Innenwiderstand R_{PG} des Pulsgenerators bekannt: R_{PG} = 1/(Faktor*Soll-Leitwert).

Es fließt somit in dem (Prüf-)Stromkreis ein voreinstellbarer Pulsstrom I_{T}, der von dem Pulsgenerator 2 über die Erdleitung 3, den Isolationsfehler und die Leitungen des IT-Netzes 1 zurück in den Pulsgenerator 2 fließt. Die Prüfstromimpulse I_{T} werden von allen Messstromwandlern erfasst, die in diesem Stromkreis fest installiert oder als portable Messstromwandler zur Isolationsfehlersuche angeordnet sind.

Der von der Steuer- und Auswertelogik 8 vorgegebene interne Strom-Sollwert w₁ ist abhängig von einem in der Steuer- und Auswertelogik 8 bestimmten Isolationswiderstandswert, zu dessen Berechnung die mittels einer Spannungsmesseinrichtung 7 gemessene IT-Netzspannung und die von der Regellogik 8 ermittelte Stellgröße y herangezogen werden.

In dem dargestellten Ausführungsbeispiel werden der Steuer- und Auswertelogik 8 als externe Signale ein System-Sollwert w₂ für den Prüfstrom I_{T} vorgegeben, aus dem die Steuer- und Auswertelogik 8 unter Einbeziehung des Isolationswiderstandes den internen Strom-Sollwert w₁ ableitet, sowie ein externes systemweites Triggersignal tr₂ als Basis für das interne Triggersignal tr₁ zur Ansteuerung der Schaltglieder 5.

Befindet sich das zu untersuchende Netz 1 in abgeschaltetem Zustand, so kann die treibende Spannung aus einem versorgenden Netz 9 bezogen werden, an das ein Netzteil 10 angekoppelt ist. Das zusätzliche Netzteil 10 speist eine galvanisch getrennte DC-Spannung in den DC-Zwischenkreis ein, die im Fall eines spannungslosen IT-Netzes 1 den Pulsstrom I_{T} treibt.

In **Fig. 3** ist demgegenüber ein Pulsgenerator 2 nach dem Stand der Technik dargestellt. Dieser Pulsgenerator weist im Wesentlichen die drei Funktionsblöcke Gleichrichterschaltung 4, Schaltglieder 5 und eine als einfachen Stromregler 6 ausgeführte Schaltungseinrichtung 6 auf. Eine dynamische Einstellung des Pulsstroms I_{T} im Sinne eines geschlossenen Regelkreises ist nicht vorgesehen.

## Patentansprüche

1. Pulsgenerator-Schaltungsanordnung zur Isolationsfehlersuche in IT-Netzen, mit einer Gleichrichterschaltung (4) zur Umwandlung der IT-Netzspannung in einen DC-Zwischenkreis, Schaltgliedern (5) mit einem Triggersignaleingang zur Auf- und Abschaltung einer DC-Zwischenkreisspannung und mit einer den Schaltgliedern nachgeordneten Schaltungseinrichtung (6) zur Erzeugung eines in das IT-Netz einzuspeisenden Pulsstroms,
**gekennzeichnet durch** eine Steuer- und Auswertelogik (8) zur Bestimmung des Isolationswiderstands des IT-Netzes und durch die Schaltungseinrichtung zur Erzeugung des Pulsstroms, die als Stromregelungseinrichtung ausgeführt ist, die eine dynamische, adaptive Einstellung des Pulsstromes in Abhängigkeit des zeitgleich ermittelten Isolationswiderstandes ermöglicht.

2. Schaltungsanordnung nach Anspruch 1,
**dadurch gekennzeichnet,**
**dass** die Stromregelungseinrichtung zur dynamischen Einstellung des Pulsstromes eine Regellogik aufweist, die eingangsseitig mit einer Strommesseinrichtung zur Ermittlung eines Strom-Istwertes des IT-Netzes sowie zur Einbeziehung eines von dem Isolationswiderstand abgeleiteten Strom-Sollwertes mit der Steuer- und Auswertelogik verbunden ist und die ausgangseitig eine Stellgröße bereitstellt, die über ein Stellglied den Strom-Istwert verändert, so dass sich am Ausgang des Stellgliedes ein angepasster Ausgangsstromwert einstellt.

3. Schaltungsanordnung nach Anspruch 1 oder 2,
**dadurch gekennzeichnet,**
**dass** die Steuer- und Auswertelogik zur Bestimmung des ohmschen Anteils des Isolationswiderstands eingangsseitig mit dem Stellgrößenausgang der Regellogik und mit einer Spannungsmesseinrichtung zur Messung der IT-Netzspannung verbunden ist und ausgangsseitig einen Strom-Sollwert an die Regellogik und ein internes Triggersignal an die Schaltglieder zur Auf- und Abschaltung der DC-Zwischenkreisspannung weitergibt.

4. Schaltungsanordnung nach einem der Ansprüche 1 bis 3,
**dadurch gekennzeichnet,**
**dass** die Steuer- und Auswertelogik weitere Eingänge für einen extern zugeführten System-Sollwert des Pulsstromes und für ein extern zugeführtes systemweites Triggersignal für die Pulsstromsequenz aufweist.

5. Schaltungsanordnung nach einem der Ansprüche 1 bis 4,
**gekennzeichnet durch**
ein zusätzliches Netzteil, das mittels einer externen Versorgungsspannung aus einem weiteren Stromversorgungsnetz eine galvanisch getrennte DC-Spannung in den DC-Zwischenkreis einspeist.

6. Verfahren zur Erzeugung von Pulssignalen zur Isolationsfehlersuche in IT-Netzen, umfassend die Signalverarbeitungsschritte:
- Umwandlung einer IT-Netzspannung in einen DC-Zwischenkreis mittels einer Gleichrichterschaltung,
- getriggerte Auf- und Abschaltung einer DC-Zwischenkreisspannung durch Schaltglieder mit einem Triggersignaleingang,
- Erzeugung eines in das IT-Netz einzuspeisenden Pulsstroms,
**gekennzeichnet durch**
- eine Bestimmung des Isolationswiderstands des IT-Netzes mittels einer Steuer- und Auswertelogik,
- die Erzeugung des in das IT-Netz eingespeisten Pulsstroms mittels einer Stromregelungseinrichtung derart, dass eine dynamische, adaptive Einstellung des Pulsstromes in Abhängigkeit des zeitgleich ermittelten Isolationswiderstandes erfolgt.

7. Verfahren nach Anspruch 6,
**dadurch gekennzeichnet,**
**dass** die Stromregelung zur dynamischen Einstellung des Pulsstromes durch eine Regellogik erfolgt, die aus einem von einer Strommesseinrichtung zugeführten Strom-Istwert des IT-Netzes und einem von der Steuer- und Auswertelogik zugeführten Isolationswiderstands-abhängigen Strom-Sollwert eine Stellgröße berechnet, die über ein Stellglied den Strom-Istwert verändert, so dass sich am Ausgang des Stellgliedes ein angepasster Ausgangsstromwert einstellt.

8. Verfahren nach Anspruch 6 oder 7,
**dadurch gekennzeichnet,**
**dass** zur Bestimmung des ohmschen Anteils des Isolationswiderstandes in der Steuer- und Auswertelogik als Eingangsgrößen die von der Regellogik gelieferte Stellgröße und die von der Spannungsmesseinrichtung bereitgestellte IT-Netzspannung herangezogen werden, wobei die Steuer- und Auswertelogik den in Abhängigkeit des ermittelten Isolationswiderstands veränderlichen Strom-Sollwert an die Regellogik weitergibt.

9. Verfahren nach Anspruch 7,
**dadurch gekennzeichnet,**
**dass** die dynamische Einstellung des Pulsstromes nach einem oder mehreren der Kriterien a) Optimierung des Arbeitsbereichs des Stellgliedes, b) Stellgröße in einem Bereich, der eine möglichst genaue Bestimmung des Isolationswiderstandes erlaubt, c) Minimierung der Verlustleistung des Stellgliedes erfolgt.

10. Verfahren nach einem der Ansprüche 6 bis 9,
**dadurch gekennzeichnet,**
**dass** der Pulsstrom einen impulsförmigen, alternierenden Verlauf aufweist.

11. Verfahren nach einem der Ansprüche 6 bis 10,
**dadurch gekennzeichnet,**
**dass** bei abgeschaltetem zu überwachenden IT-Netz eine galvanisch getrennte DC-Spannung mittels einer externen Versorgungsspannung aus einem weiteren Stromversorgungsnetz in den DC-Zwischenkreis eingespeist wird.

## Claims

1. A pulse generator circuit arrangement for insulation fault location in IT networks, comprising a rectifier circuit (4) for transforming the IT network voltage into a DC intermediate circuit, switching elements (5) having a trigger signal input for switching on and off a DC intermediate circuit voltage, and comprising, downstream of the switching elements, a circuit device (6) for generating a pulsed current to be supplied to the IT network,
**characterized by**
a control and evaluating logic (8) for determining the insulation resistance of the IT network and by the circuit device for generating the pulsed current, which is configured as a current regulating device which allows a dynamic adaptive adjustment of the pulsed current depending on the simultaneously determined insulation resistance.

2. The circuit arrangement according to claim 1,
**characterized in that**
for the dynamic adjustment of the pulsed current, the current regulating device has a regulating logic which is connected on the input side to a current measuring device for determining an actual current value of the IT network and also to the control and evaluating logic for including a target current value derived from the insulation resistance and which on the output side provides a correcting value which changes the actual current value via an actuator so that at the output of the actuator an adjusted output current value occurs.

3. The circuit arrangement according to claim 1 or 2,
**characterized in that**
the control and evaluating logic for determining the ohmic part of the insulation resistance is connected on the input side to the correcting value output of the regulating logic and to a voltage measuring device for measuring the IT network voltage and on the output side it passes on a target current value to the regulating logic and an internal trigger signal to the switching elements for switching on and off the DC intermediate circuit voltage.

4. The circuit arrangement according to any of the claims 1 to 3,
**characterized in that**
the control and evaluating logic has further inputs for an externally supplied target system value of the pulsed current and for an externally supplied system-wide trigger signal for the pulsed current sequence.

5. The circuit arrangement according to any of the claims 1 to 4,
**characterized by**
an additional power supply unit which, by means of an external supply voltage from another power supply network, supplies a galvanically isolated DC voltage into the DC intermediate circuit.

6. A method for generating pulsed signals for insulation fault location in IT networks, comprising the signal processing steps:
- transformation of an IT network voltage into a DC intermediate circuit by means of a rectifier circuit,
- triggered switching on and off of a DC intermediate circuit voltage by means of switching elements having a trigger signal input,
- generation of a pulsed current to be supplied to the IT network, **characterized by**
- a determination of the insulation resistance of the IT network by means of a control and evaluating logic,
- the generation of the pulsed current supplied to the IT network by means of a current regulating device in such a manner that a dynamic adaptive adjustment of the pulsed current takes place depending on the simultaneously determined insulation resistance.

7. The method according to claim 6,
**characterized in that**
the current regulation for the dynamic adjustment of the pulsed current takes place by means of a regulating logic which calculates a correcting value from an actual current value of the IT network supplied by a current measuring device and from a target current value depending on the insulation resistance and supplied by the control and evaluating logic, the correcting value changing the actual current value via an actuator so that at the output of the actuator an adjusted output current value occurs.

8. The method according to claim 6 or 7,
**characterized in that**
for determining the ohmic part of the insulation resistance, the correcting value supplied by the regulating logic and the IT network voltage provided by the voltage measuring device are used as input values in the control and evaluating logic, wherein the control and evaluating logic passes on the target current value to the regulating logic, the target current value being variable depending on the determined insulation resistance.

9. The method according to claim 7,
**characterized in that**
the dynamic adjustment of the pulsed current takes place according to one or more of the criteria a) optimization of the operating range of the actuator, b) correcting value in a range which allows a determination as exact as possible of the insulation resistance, c) minimization of the power dissipation of the actuator.

10. The method according to any of the claims 6 to 9,
**characterized in that**
the pulsed current has a pulse-shaped, alternating flow.

11. The method according to any of the claims 6 to 10,
**characterized in that**
when the IT network to be monitored is shut down, a galvanically isolated DC voltage is supplied to the DC intermediate circuit by means of an external supply voltage from another power supply network.

## Revendications

1. Agencement de circuit de générateur d'impulsions pour la localisation de défauts d'isolement dans des réseaux IT, comprenant un circuit redresseur (4) destiné à transformer la tension du réseau IT en un circuit intermédiaire DC, des éléments de commutation (5) ayant une entrée de signal déclencheur pour mettre sous et hors tension le circuit intermédiaire DC, et comprenant, en aval des éléments de commutation, un dispositif de circuit (6) destiné à générer un courant pulsé à injecter dans le réseau IT,
**caractérisé par**
une logique de commande et d'évaluation (8) destinée à déterminer la résistance d'isolement du réseau IT et par le dispositif de circuit destiné à générer le courant pulsé, qui est configuré comme dispositif de régulation de courant qui permet au courant pulsé d'être ajusté de manière dynamique et adaptive en fonction de la résistance d'isolement déterminée simultanément.

2. Agencement de circuit selon la revendication 1,
**caractérisé en ce qu'**
afin d'ajuster dynamiquement le courant pulsé, le dispositif de régulation de courant a une logique de régulation qui est connectée, du côté d'entrée, à un dispositif de mesure de courant destiné à déterminer une valeur réelle de courant du réseau IT et aussi à la logique de commande et d'évaluation afin de tenir compte d'une valeur désirée de courant dérivée de la résistance d'isolement et qui fournit, du côté de sortie, une valeur de réglage qui change la valeur réelle de courant à l'aide d'un actionneur de sorte qu'une valeur de sortie de courant ajustée se présente à la sortie de l'actionneur.

3. Agencement de circuit selon la revendication 1 ou 2,
**caractérisé en ce qu'**
afin de déterminer la part ohmique de la résistance d'isolement, la logique de commande et d'évaluation est connectée, du côté d'entrée, à la sortie de valeur de réglage de la logique de régulation et à un dispositif de mesure de tension destiné à mesurer la tension du réseau IT et, du côté de sortie, elle transmet une valeur désirée de courant à la logique de régulation et un signal déclencheur interne aux éléments de commutation afin de mettre sous et hors tension le circuit intermédiaire DC.

4. Agencement de circuit selon l'une quelconque des revendications 1 à 3,
**caractérisé en ce que**
la logique de commande et d'évaluation a d'autres entrées pour une valeur désirée de système, amenée de manière externe, du courant pulsé et pour un signal déclencheur amené de manière externe au niveau de l'ensemble du système pour la séquence du courant pulsé.

5. Agencement de circuit selon l'une quelconque des revendications 1 à 4,
**caractérisé par**
un bloc d'alimentation additionnel qui injecte une tension DC séparée galvaniquement dans le circuit intermédiaire DC à l'aide d'une tension d'alimentation externe à partir d'un autre réseau d'alimentation électrique.

6. Procédé de génération de signaux pulsés pour la localisation de défauts d'isolement dans des réseaux IT, comprenant les étapes de traitement de signal consistant à :
- transformer une tension du réseau IT en un circuit intermédiaire DC à l'aide d'un circuit redresseur,
- mettre sous et hors tension de manière déclenchée le circuit intermédiaire DC à l'aide d'éléments de commutation ayant une entrée de signal déclencheur,
- générer un courant pulsé à fournir au réseau IT, **caractérisé par**
- une détermination de la résistance d'isolement du réseau IT à l'aide d'une logique de commande et d'évaluation,
- la génération du courant pulsé fourni au réseau IT à l'aide d'un dispositif de régulation de courant de telle manière que le courant pulsé est ajusté de manière dynamique et adaptive en fonction de la résistance d'isolement déterminée simultanément.

7. Procédé selon la revendication 6,
**caractérisé en ce que**
la régulation de courant pour l'ajustement dynamique du courant pulsé est effectuée par un logique de régulation qui calcule une valeur de réglage à partir d'une valeur réelle de courant du réseau IT fournie par un dispositif de mesure de courant et à partir d'une valeur désirée de courant dépendant d'une résistance d'isolement et fournie par la logique de commande et d'évaluation, la valeur de réglage changeant la valeur réelle de courant à l'aide d'un actionneur de sorte qu'une valeur de courant de sortie ajustée se présente à la sortie de l'actionneur.

8. Procédé selon la revendication 6 ou 7,
**caractérisé en ce que**
pour la détermination de la part ohmique de la résistance d'isolement, la valeur de réglage fournie par la logique de régulation et la tension du réseau IT fournie par le dispositif de mesure de tension sont utilisées comme valeurs d'entrée dans la logique de commande et d'évaluation, la logique de commande et d'évaluation transmettant la valeur désirée de courant, qui est variable en fonction de la résistance d'isolement déterminée, à la logique de régulation.

9. Procédé selon la revendication 7,
**caractérisé en ce que**
le courant pulsé est ajusté dynamiquement selon un ou plusieurs des critères a) optimisation de la portée de travail de l'actionneur, b) valeur de réglage dans une gamme qui permet de déterminer le plus précisément possible la résistance d'isolement, c) minimisation de la perte de puissance de l'actionneur.

10. Procédé selon l'une quelconque des revendications 6 à 9,
**caractérisé en ce que**
le courant pulsé a une progression alternante sous forme d'impulsions.

11. Procédé selon l'une quelconque des revendications 6 à 10,
**caractérisé en ce que**
quand le réseau IT à surveiller est déconnecté, le circuit intermédiaire DC est alimenté en une tension DC galvaniquement isolée à l'aide d'une tension d'alimentation externe à partir d'un autre réseau d'alimentation électrique.
